# FASCICULE DE BREVET EUROPEEN

(11) **EP 4 631 112 B1**
(45) Date de publication et mention de la délivrance du brevet: **22.04.2026**
(21) Numéro de dépôt: 23841278.7
(22) Date de dépôt: 01.12.2023
(51) Int. Cl.: H10F 30/21, H10F 30/225, H10F 77/124, H10F 30/24, H10F 77/14

(54) **PHOTODETECTEUR MWIR A BARRIERE DONT LA ZONE ABSORBANTE COMPORTE UN EMPILEMENT D'UNE PARTIE MASSIVE ET D'UN SUPER-RESEAU**
MWIR-BARRIERENFOTODETEKTOR MIT EINEM STAPEL AUS EINEM FESTEN TEIL UND EINEM ÜBERGITTER IN DER SAUGFÄHIGEN ZONE
MWIR BARRIER PHOTODETECTOR IN WHICH THE ABSORBENT ZONE COMPRISES A STACK OF A SOLID PORTION AND A SUPERLATTICE

(30) Priorité: 05.12.2022 FR 2212750
(43) Date de publication de la demande: 15.10.2025
(73) Titulaire: Commissariat à l'Energie Atomique et aux Energies Alternatives, 75015 Paris (FR); LYNRED, 91127 Palaiseau (FR)
(72) Inventeur: GRAVRAND, Olivier, 38054 Grenoble Cedex 09 (FR); PERE LAPERNE, Nicolas, 38113 Veurey-Voroize (FR)
(74) Mandataire: Santarelli
(86) Numéro de dépôt international: PCT/FR2023/051896
(87) Numéro de publication internationale: WO 2024/121491

(56) Documents cités:
- US-A1- 2002 125 472
- US-A1- 2010 072 514
- US-A1- 2014 225 064
- US-B1- 9 698 192

## Description

### DOMAINE TECHNIQUE

Le domaine de l'invention est celui des photodétecteurs MWIR comportant une structure semiconductrice à barrière et réalisée à base de III-Sb.

### ÉTAT DE LA TECHNIQUE ANTÉRIEURE

Dans le domaine de la détection infrarouge, de nombreux développements existent pour obtenir des photodétecteurs plus performants, et adaptés à détecter dans le moyen infrarouge (MWIR, pour *Middle Wave Infrared* en anglais), i.e. dans la bande spectrale allant de 3 à 5µm environ. Il peut ainsi s'agir d'être en mesure d'utiliser de tels photodétecteurs à des températures de fonctionnement supérieures aux températures cryogéniques habituelles, par exemple autour de 120 à 170K. On parle alors de photodétecteurs MWIR HOT, pour *High Operating Temperature* en anglais.

Les photodétecteurs MWIR peuvent être des photodétecteurs à barrière (ou bariode, pour diode à barrière) de type XBn ou XBp, c'est-à-dire qu'ils comportent alors une structure semiconductrice formée d'un empilement d'une couche contact notée X (dopée de type n ou de type p), d'une couche barrière notée B, et d'une zone absorbante dopée n ou p selon le type de la bariode. La barrière est dite unipolaire dans la mesure où elle bloque les porteurs de charge d'un type de conductivité mais autorise le déplacement des porteurs de charge de l'autre type de conductivité. Ainsi, dans le cas d'une bariode XBn, la couche barrière bloque les électrons majoritaires mais autorise le déplacement jusqu'à la couche contact des trous photogénérés dans la zone absorbante. Une présentation de tels photodétecteurs MWIR à barrière se trouve notamment dans la publication de Martyniuk et al. intitulé Barrier infrared detectors, Opto-Electron. Rev., 22, no. 2, 2014. On peut également se référer au document US7795640B2.

D'une manière générale, les photodétecteurs à barrière ont l'avantage que le courant de recombinaison SRH (Shockley-Read-Hall) est d'une faible contribution au courant d'obscurité, en comparaison à sa contribution dans le cas des photodiodes à jonction pn. En effet, dans de telles photodiodes à jonction pn, la contribution du courant SRH peut être élevée dans la zone de charge d'espace dans la mesure où l'énergie de bande interdite (gap) des composés semiconducteurs habituellement utilisés pour la détection infrarouge est faible. En revanche, dans un photodétecteur à barrière, la zone de champ électrique est confinée dans la couche barrière à grand gap, et joue le même rôle que la zone de charge d'espace : bloquer les porteurs majoritaires tout en laissant passer les porteurs minoritaires photogénérés. La contribution du courant GR (courant de génération-recombinaison) au courant d'obscurité est alors fortement réduite. Par ailleurs, pour ne pas entraver le photocourant, la couche barrière présente un faible offset de la bande de valence (dans le cas des bariodes de type XBn).

Les photodétecteurs à barrière peuvent notamment être réalisés à base de composés III-V à base d'antimoniure (Sb), qui permettent notamment, dans le cas des photodétecteurs de type XBn, d'obtenir un offset de la bande de valence très faible. La zone d'absorption est alors généralement réalisée par épitaxie à partir d'un substrat à base de III-Sb, par exemple en GaSb. Elle peut être réalisée en un matériau dit massif *(bulk* en anglais), par exemple en InAsSb, ou peut être réalisée sous la forme d'un super-réseau (*super lattice* en anglais), par exemple un super-réseau de type 2 (T2SL, pour *Type-2 Super Lattice* en anglais).

Les super-réseaux et les matériaux massifs se distinguent l'un de l'autre notamment par les propriétés de transport des porteurs de charge, et en particulier des porteurs minoritaires, dans le matériau considéré. Dans un matériau massif non contraint ou en accord de maille, le transport des porteurs minoritaires est isotrope : ils peuvent se déplacer dans les trois dimensions de l'espace sans contraintes. En revanche, dans un super-réseau, le transport de ces porteurs minoritaires est anisotrope : le transport latéral dans le plan des couches, i.e. dans un plan orthogonal à l'axe de croissance est plus élevé (et proche du transport dans un matériau massif) que le transport vertical suivant l'axe orthogonal au plan des couches, du fait de la présence des barrières de potentiel du super-réseau.

Ces deux familles technologiques (matériaux massifs et super-réseaux) présentent des propriétés d'absorption différentes dans la bande spectrale MWIR, et sont différemment utilisées selon que l'on souhaite détecter dans une partie seulement ou dans toute la bande spectrale MWIR.

En effet, rappelons que la bande spectrale MWIR, qui correspond à une fenêtre de transmission atmosphérique, est divisée en deux sous-bandes situées de part et d'autre de la longueur d'onde d'absorption du CO₂ à 4.2µm : une 'bande bleue' pour les longueurs d'onde en deçà de 4.2µm, et une 'bande rouge' pour les longueurs d'onde au-delà de 4.2µm.

Aussi, les photodétecteurs MWIR à barrière dont la zone absorbante est réalisée en un matériau massif en InAsSb (en accord de maille avec un substrat GaSb) sont utilisés pour détecter le rayonnement lumineux essentiellement dans la 'bande bleue' du moyen infrarouge, du fait de la longueur d'onde de coupure de l'InAsSb à 4.1µm à 150K. Par ailleurs, concernant l'InSb, il n'est pas réalisé à partir d'un substrat GaSb. De plus, bien qu'il présente une longueur d'onde de coupure plus élevée (5.5µm à 77K), l'augmentation de la température de fonctionnement conduit à une dégradation du courant d'obscurité lié au décalage du gap de l'InSb à haute température.

Par ailleurs, les photodétecteurs infrarouge dont la zone absorbante est formée d'un super-réseau peuvent absorber le rayonnement lumineux dans toute la bande spectrale MWIR, i.e tant dans la 'bande bleue' que dans la 'bande rouge', tout en conservant l'accord de maille avec le substrat GaSb. Cependant, outre les difficultés de réalisation d'une telle couche absorbante à super-réseau, l'augmentation de la température de fonctionnement conduit également à une dégradation du courant d'obscurité. De plus, le transport anisotrope des porteurs de charge se traduit par une faible efficacité quantique et, dans le cas d'un photodétecteur matriciel, dégrade la fonction de transfert de modulation (FTM).

### EXPOSÉ DE L'INVENTION

L'invention a pour objectif de remédier au moins en partie aux inconvénients de l'art antérieur, et plus particulièrement de proposer un photodétecteur MWIR à barrière, adapté à détecter un rayonnement lumineux sur toute la bande spectrale MWIR, et présentant des performances améliorées à une température de fonctionnement nominale, ou des performances nominales mais à une température de fonctionnement plus élevée.

Pour cela, l'objet de l'invention est un photodétecteur MWIR à barrière, adapté à détecter un rayonnement lumineux d'intérêt présentant une longueur d'onde centrale comprise entre 3 et 5µm. La longueur d'onde centrale peut être une longueur d'onde quelconque située dans cette bande spectrale. Le photodétecteur comporte une structure semiconductrice à barrière, réalisée à base de III-Sb, reposant sur un substrat support réalisé à base de III-Sb, et formée de : une zone absorbante, adaptée à absorber le rayonnement lumineux d'intérêt ; une couche barrière ; puis une couche contact.

La zone absorbante est formée d'un empilement de deux parties : une première partie absorbante, dopée selon un premier type de conductivité, réalisée en un matériau massif à base d'InAsSb, située du côté du substrat support ; et une deuxième partie absorbante, dopée selon le premier type de conductivité, et formée d'un super-réseau, située entre la première partie absorbante et la couche barrière.

Certains aspects préférés mais non limitatifs de ce photodétecteur MWIR sont les suivants.

Le photodétecteur peut comporter une matrice de pixels de détection, la première partie absorbante étant une couche continue et commune à chaque pixel de détection.

La couche contact peut être réticulée et être formée d'une pluralité de portions distinctes les unes des autres. La couche barrière peut être réticulée et être formée d'une pluralité de portions distinctes les unes des autres, et la deuxième partie absorbante peut être réticulée et être formée d'une pluralité de portions distinctes les unes des autres, chaque pixel de détection étant formé d'une mésa reposant sur la première partie absorbante, chaque mésa étant formée par une portion de la couche contact réticulée, une portion de la couche barrière réticulée, et une portion de la deuxième partie absorbante réticulée.

En variante, la couche contact peut être réticulée et être formée d'une pluralité de portions distinctes les unes des autres, chaque pixel de détection étant formé d'une portion de la couche contact, la deuxième partie absorbante étant une couche continue et commune à chaque pixel de détection.

Le photodétecteur peut comporter une couche intermédiaire située entre et au contact de la première partie absorbante et la deuxième partie absorbante, la couche intermédiaire étant une couche continue et commune à chaque pixel de détection.

La première partie absorbante peut être réalisée à base d'InAsSb en accord de maille avec le substrat support.

La deuxième partie absorbante peut être réalisée à base d'InAs/InAsSb, d'InAs/AlSb ou d'InAs/GaSb.

La première partie absorbante peut présenter une épaisseur supérieure à celle de la deuxième partie absorbante.

La première partie absorbante peut présenter une épaisseur au moins égale à la moitié de celle de la zone absorbante
La structure semiconductrice à barrière peut être de type XBn, la bande de valence de la deuxième partie absorbante présentant une énergie supérieure à celle de la bande de valence de la première partie absorbante. En variante, la structure semiconductrice à barrière peut être de type XBp, la bande de conduction de la deuxième partie absorbante présentant une énergie inférieure à celle de la bande de conduction de la première partie absorbante.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique et partielle, en coupe transversale, d'un photodétecteur MWIR à barrière selon un mode de réalisation ;
la figure 1B illustre un diagramme de bande d'énergie du photodétecteur MWIR de la fig.1A ;
la figure 2A est une vue schématique et partielle, en coupe transversale, d'un photodétecteur matriciel MWIR à barrière selon un mode de réalisation, dont la pixellisation présente une configuration gravure peu profonde (*shallow-etch* en anglais) ;
la figure 2B est une vue schématique et partielle, en coupe transversale, d'un photodétecteur matriciel MWIR à barrière selon un autre mode de réalisation, dont la pixellisation présente une configuration intermédiaire entre la configuration gravure peu profonde (*shallow-etch*) et la configuration gravure profonde (*deep-etch* en anglais).

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un photodétecteur infrarouge à barrière (bariode) adapté à détecter un rayonnement lumineux dans toute la gamme du moyen infrarouge (MWIR), c'est-à-dire entre 3 et 5µm environ. Le photodétecteur est donc adapté à détecter un rayonnement infrarouge tant dans la 'bande bleue' (3 - 4.2µm environ) que dans la 'bande rouge' (4.2 - 5µm environ).

En comparaison avec un photodétecteur MWIR à barrière conventionnel dont la zone absorbante serait formée d'un seul super-réseau (bariode MWIR T2SL conventionnelle), le photodétecteur MWIR selon l'invention présente des performances améliorées à la température de fonctionnement nominale de la bariode conventionnelle, ou alors présente des performances similaires mais à une température de fonctionnement plus élevée par exemple de 5 à 10K supérieure.

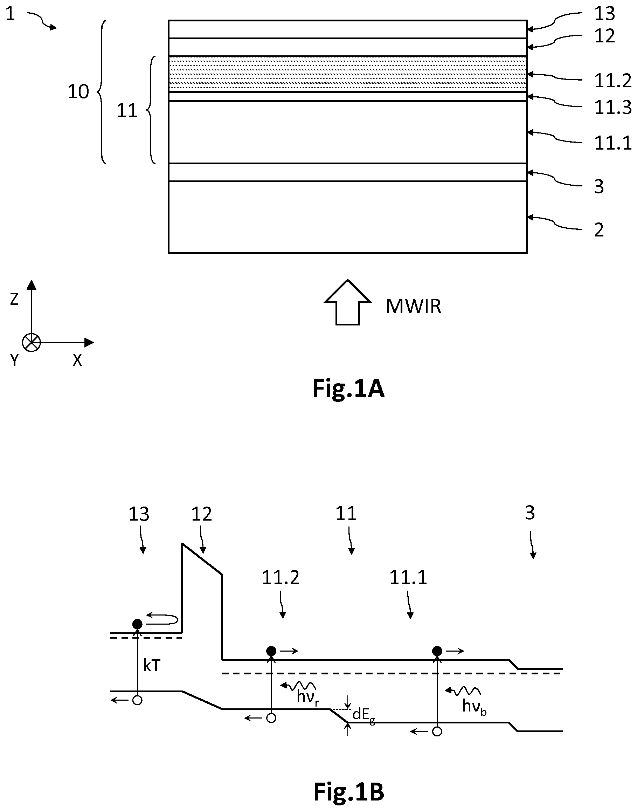

La figure 1A est une vue schématique et partielle, en coupe transversale, d'un photodétecteur 1 à barrière adapté à détecter un rayonnement lumineux dans toute la gamme spectrale de l'infrarouge moyen (MWIR). Dans cet exemple, la structure semiconductrice 10 à barrière est de type nBn mais elle peut tout aussi bien est de type pBn, voire de type XBp (nBp ou pBp).

On définit ici et pour la suite de la description un repère direct tridimensionnel orthogonal XYZ, où les axes X et Y forment un plan parallèle au plan des couches de la structure semiconductrice 10 à barrière, et où l'axe Z est orienté suivant la direction de croissance des couches.

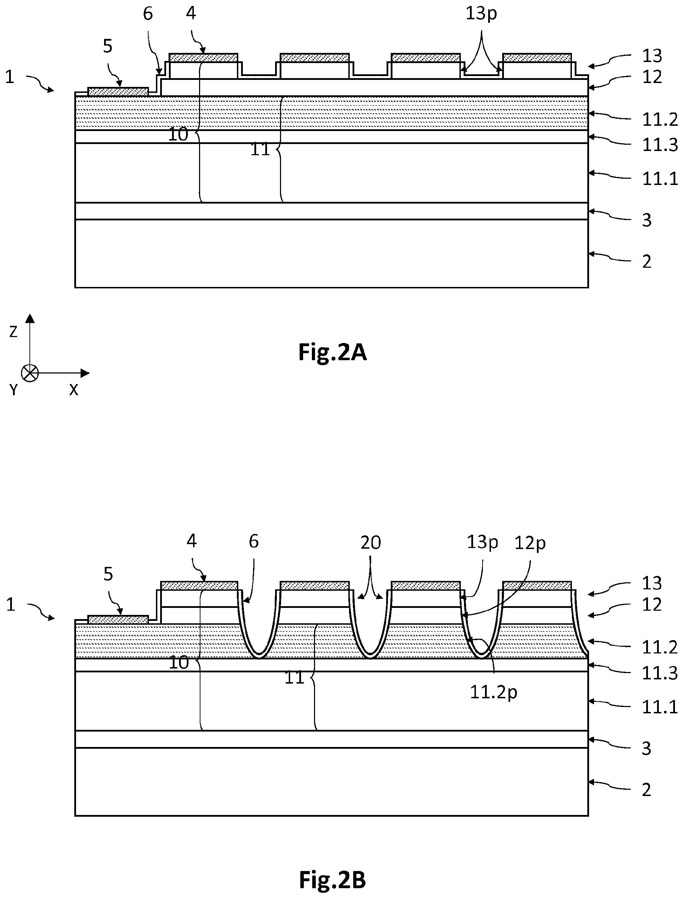

D'une manière générale, le photodétecteur 1 comporte une structure semiconductrice 10 à barrière, réalisée par épitaxie à partir d'un substrat support 2, cette structure semiconductrice 10 étant formée d'un empilement d'une zone absorbante 11, d'une couche barrière 12, puis d'une couche contact 13. Des électrodes 4, 5 (cf. fig.2A) sont également présentes pour appliquer une différence de potentiel électrique à la structure semiconductrice 10 et collecter le photocourant.

Le substrat support 2 est réalisée en un matériau au moins partiellement transparent dans la bande spectrale MWIR, dans la mesure où le rayonnement lumineux est ici incident sur la face opposée à la structure semiconductrice 10 à barrière. Il forme également un substrat de croissance à partir duquel la structure semiconductrice 10 à barrière est réalisée par épitaxie. Il est alors réalisé en un matériau cristallin à base de III-Sb, et est réalisé ici en GaSb.

Une couche inférieure 3 peut être présente entre le substrat support 2 et la zone absorbante 11 de la structure semiconductrice 10 à barrière. Elle peut être réalisée en le même matériau cristallin que celui de la première partie absorbante 11.1, par exemple en InAs_{0.9}Sb_{0.1} massif. Il peut être surdopé, ici de type n, pour assurer une faible résistance série entre les électrodes 4 et 5, en particulier dans le cas d'une grande matrice de pixels où l'électrode 5 serait située en périphérie des pixels sensibles. Le niveau de dopage peut être par exemple supérieur à celui de la première partie absorbante 11.1, par exemple égal à 10¹⁷ cm⁻³. L'épaisseur peut être comprise entre 0.1 et 1µm, par exemple égale à 0.5µm.

La zone absorbante 11 est la zone où le rayonnement lumineux incident MWIR est absorbé. Elle est formée d'un empilement d'une première partie absorbante 11.1 réalisée en un matériau semiconducteur cristallin massif à base de III-Sb, et d'une deuxième partie absorbante 11.2 formée d'un super-réseau. Elle s'étend entre le substrat support 2 (et ici est au contact de la couche inférieure 3) et la couche barrière 12. Elle présente une épaisseur adaptée à assurer l'absorption du rayonnement lumineux incident dans toute la gamme MWIR. L'épaisseur peut alors être comprise entre 2 et 8µm, par exemple égale à 5µm.

La première partie absorbante 11.1, dite massive, est située entre le substrat support 2 et la deuxième partie absorbante SL 11.2. Elle est réalisée en un composé semiconducteur cristallin massif à base d'III-Sb, par exemple ici en InAsSb. Elle est donc adaptée à absorber le rayonnement lumineux principalement dans la 'bande bleue' du MWIR.

La première partie absorbante 11.1 est dite massive, dans la mesure où elle est réalisée en un composé semiconducteur lui-même massif, c'est-à-dire en un composé dont la composition chimique (la proportion atomique x de l'antimoine Sb, dans le cas ici de l'InAs₁₋ₓSbₓ) est homogène ou varie suivant l'axe de croissance Z, sans pour autant former un système de puits quantiques multiples couplés.

Ainsi, la composition chimique (proportion atomique x de l'antimoine) du composé semiconducteur massif InAs₁₋ₓSbₓ peut être homogène dans tout le volume considéré, ici dans celui de la première partie absorbante 11.1. On peut également envisager une variation affine de la composition chimique (et donc de l'énergie de bande interdite) sur tout ou partie de l'épaisseur de la première partie absorbante 11.1.

Par ailleurs, il est connu qu'un composé semiconducteur massif InAs₁₋ₓSbₓ peut également être un alliage digital (*digital alloy,* en anglais), c'est-à-dire un composé formé d'une alternance de couches fines d'InAsSb et d'InAs, de sorte que le composé résultant InAs₁₋ₓSbₓ se comporte comme la composition chimique moyenne des couches et non comme un super-réseau (pas de développement de niveaux discrets dans les puits quantiques formés). Pour cela, les couches fines d'au moins l'un des matériaux (de préférence les couches d'InAsSb) présentent une épaisseur maximale inférieure à l'étendue spatiale de la fonction d'onde de l'électron, par exemple égale au plus à 4 monocouches, de manière à éviter le couplage des puits quantiques.

Le composé semiconducteur massif est en accord de maille avec le substrat support 2, et est ici de l'InAs_{0.9}Sb_{0.1} avec une proportion atomique d'antimoine Sb de l'ordre de 10%. Autrement dit, le paramètre de maille de la première partie absorbante 11.1 est sensiblement égal à celui du substrat support 2. Il est ici au contact de la couche inférieure 3 dans la mesure où il a été épitaxié à partir de cette couche.

Par ailleurs, le composé semiconducteur massif est dopé selon un type de conductivité qui dépend du type de structure semiconductrice 10 à barrière. Dans cet exemple où elle est de type nBn, le composé semiconducteur massif est dopé de type n. Le niveau de dopage peut être compris entre 10¹⁵cm⁻³ et 5×10¹⁶cm⁻³, et est égal ici à 10¹⁵ cm⁻³ environ. Il peut être constant dans le volume de la première partie absorbante massive 11.1. En variante, pour orienter les trous minoritaires en direction de la deuxième partie absorbante SL 11.2, le dopage peut varier suivant la direction +Z, et par exemple passer de 5×10¹⁶cm⁻³ à 10¹⁵cm⁻³.

La première partie absorbante massive 11.1 présente une épaisseur de préférence au moins égale à la moitié de l'épaisseur de la zone absorbante 11. Elle peut être comprise entre 1 et 4µm, par exemple égale à 3µm environ dans cet exemple où la zone absorbante 11 présente une épaisseur de 5µm environ. Elle est de préférence supérieure à l'épaisseur de la deuxième partie absorbante SL 11.2.

La zone absorbante 11 peut comporter une couche intermédiaire 11.3, située entre et au contact de la première partie absorbante massive 11.1 et la deuxième partie absorbante SL 11.2. Elle peut permettre de lissertoute barrière de potentiel se développant à l'interface entre les deux parties 11.1 et 11.2 susceptible de perturber le transport des porteurs minoritaires vers la couche contact 13 ainsi que la conduction des porteurs majoritaires. Elle peut également améliorer le transport des trous minoritaires photogénérés à partir de la première partie absorbante massive 11.1 en direction de la couche contact 13 par ce lissage de barrière de potentiel pouvant se développer. Pour cela, la couche intermédiaire 11.3 peut être réalisée à base de III-Sb, par exemple en InAsGaSb dopée ici de type n (la zone absorbante 11 étant ici de type n) et d'une épaisseur par exemple égale à 0.5µm.

La deuxième partie absorbante 11.2, dite SL pour super-réseau (*Super Lattice* en anglais), est située entre la première partie absorbante 11.1 et la couche barrière 12. Elle est formée d'un super-réseau à base de III-Sb, ici un super-réseau de préférence de type II. Elle est donc adaptée à absorber le rayonnement lumineux tant dans la bande bleue que la bande rouge du MWIR. Etant donné que le rayonnement lumineux incident appartenant à la bande bleue est principalement absorbé dans la première partie absorbante massive 11.1, la deuxième partie absorbante SL 11.2 assure l'absorption essentiellement dans la bande rouge.

Comme indiqué précédemment, un super-réseau est un empilement périodique de couches fines (de l'ordre de quelques nanomètres) de composés semiconducteurs différents. Cet empilement forme un système de puits quantiques multiples couplés. Il peut être réalisé en InAs/GaSb ou en InAs/AlSb, voire en InAs/InAsSb, entre autres, dont le dopage est ici de type n dans la mesure où la structure semiconductrice 10 à barrière est ici de type XBn. Les matériaux du super-réseau peuvent être dopés de type n, par exemple avec un niveau de dopage du même ordre de grandeur que celui de la première partie absorbante massive 11.1. Ainsi, la zone absorbante 11 présente un même type de conductivité dans tout son volume, ici de type n.

La deuxième partie absorbante SL 11.2 présente une épaisseur totale de préférence au plus égale à la moitié de celle de la zone absorbante 11. Elle peut être comprise entre 1 et 4µm, et est par exemple égale à 1.5µm environ dans cet exemple où la zone absorbante présente une épaisseur de 5µm environ. Son épaisseur est inférieure à la longueur de diffusion des porteurs minoritaires photogénérés. De préférence, elle est inférieure à celle de la première partie absorbante massive 11.1 de manière à améliorer les performances du photodétecteur 1 en termes de courant d'obscurité. Cependant, une épaisseur sensiblement égale à celle de la première partie absorbante massive 11.1 permet d'optimiser la FTM.

De préférence, la deuxième partie absorbante SL 11.2 présente une structure de bande présentant, comme l'illustre la fig.1B, un alignement de la bande de conduction avec celle de la première partie absorbante massive 11.1, mais un léger offset dE_{g} de la bande de valence (l'énergie de la bande de valence de la partie 11.2 étant supérieure à celle de la partie 11.1), améliorant ainsi le transport des trous minoritaires en direction de la couche contact 13. En effet, les trous minoritaires générés dans la deuxième partie absorbante SL 11.2 n'iront pas diffuser dans la première partie absorbante massive 11.1, améliorant ainsi la FTM du photodétecteur 1. Cet offset dE_{g} est obtenu par le choix des matériaux et de la période des couches fines de la partie SL 11.2, mais également par l'ajustement des niveaux de dopages de la partie massive 11.1 et de la partie SL 11.2. Notons que, dans le cas d'une bariode de type XBp, l'offset dE_{g} est celui de la bande de conduction (électrons minoritaires). Aussi, l'énergie de la bande de conduction de la partie 11.2 est inférieure à celle de la partie 11.1.

La couche barrière 12 est située entre la zone absorbante 11 et la couche contact 13, et est ici au contact de la deuxième partie absorbante SL 11.2. La structure semiconductrice 10 à barrière étant ici de type XBn, la couche barrière 12 présente un fort offset de la bande de conduction et un faible offset de la bande de valence, et permet ainsi de bloquer le transport des électrons majoritaires tout en autorisant celui des trous minoritaires photogénérés en direction de la couche contact 13.

Elle est réalisée en un matériau semiconducteur cristallin à base d'III-Sb présentant un gap supérieur à ceux de la zone absorbante 11. A titre d'exemple, la couche barrière 12 peut être réalisée à base d'InAlAsSb (ici en InAlAsSb). Le matériau peut être ici dopé de type n, par exemple à un niveau de dopage égal à 10¹⁶cm⁻³ environ. L'épaisseur peut être comprise entre 0.05 et 0.5µm, par exemple égale à 0.1µm.

La couche contact 13 est située au contact de la couche barrière 12. Elle est réalisée en un matériau à base d'III-Sb, par exemple en InAsSb, dopé de type n dans le cas ici d'une structure semiconductrice 10 à barrière de type nBn. Le niveau de dopage peut être compris entre 10¹⁵cm⁻³ et 10¹⁸cm⁻³, et être par exemple de l'ordre de 10¹⁷ cm⁻³. L'épaisseur peut être comprise entre 0.05 et 1µm, par exemple égale à 0.5µm.

Au moins une première électrode 4 est située au contact de la couche contact 13, et permet d'appliquer un potentiel électrique à la structure semiconductrice 10 à barrière et de collecter le photocourant. Au moins une deuxième électrode 5 est située au contact de la structure semiconductrice 10 à barrière pour lui appliquer un potentiel électrique différent. La deuxième électrode 5 peut être au contact du substrat support 2, de la couche inférieure 3, de la première partie absorbante massive 11.1, voire de la deuxième partie absorbante SL 11.2 (comme illustré sur la fig.2A et la fig.2B).

Ainsi, comme le montre la figure 1B qui illustre un exemple de diagramme de bande d'énergie du photodétecteur 1 selon un mode de réalisation de l'invention, le rayonnement lumineux incident appartenant à la bande bleue du MWIR est principalement absorbé dans la première partie absorbante massive 11.1. Les trous photogénérés 'bleus' vont ensuite diffuser jusqu'à la couche contact 13. De plus, le rayonnement lumineux incident appartenant à la bande rouge du MWIR est principalement absorbé dans la deuxième partie absorbante SL 11.2, et les trous photogénérés 'rouges' vont également diffuser jusqu'à la couche contact 13. En revanche, la couche barrière 12 va bloquer le transport des électrons majoritaires, et surtout limiter la contribution des porteurs majoritaires au courant d'obscurité.

Ainsi, par le fait que la zone absorbante 11 est formée d'une première partie absorbante massive 11.1 et d'une deuxième partie absorbante SL 11.2, le photodétecteur 1 est en mesure d'absorber le rayonnement lumineux incident dans toute la gamme spectrale MWIR, et présente soit des performances améliorées à la température de fonctionnement nominale d'une photodiode conventionnelle où la zone absorbante ne serait formée que d'un super-réseau T2SL, soit des performances maintenues mais à une température de fonctionnement plus élevée.

Ainsi, pour une température de fonctionnement nominale de 130 à 140K par exemple, et grâce à la qualité cristalline du matériau massif de la première partie absorbante massive 11.1, il apparaît que le photodétecteur 1 selon l'invention permet de réduire le courant d'obscurité associé à la zone absorbante 11, comparé à celui de la photodiode conventionnelle MWIR T2SL. De plus, cette même première partie absorbante massive 11.1, par ses propriétés de transport isotrope, permet d'améliorer l'efficacité quantique QE associée à la zone absorbante 11, en comparaison à celui de la photodiode conventionnelle MWIR T2SL. En effet, dans le cas d'un T2SL épais conventionnel, la longueur de diffusion verticale (suivant l'axe Z) est faible, si bien que l'efficacité quantique QE se dégrade rapidement dès que l'épaisseur du T2SL est plus importante que cette longueur de diffusion. Rappelons ici que l'efficacité quantique QE est définie comme étant le nombre de paires électron-trou générées et collectées par photon incident. Par ailleurs, si l'on souhaite garder des performances identiques à celles de la photodiode conventionnelle MWIR T2SL, en termes notamment de courant d'obscurité et d'efficacité quantique, le photodétecteur 1 selon l'invention peut être utilisé à une température de fonctionnement supérieure, par exemple de 140 à 150K.

Par ailleurs, comme détaillé plus loin, la présence de la première partie absorbante massive 11.1 dans la zone absorbante 11 permet, dans le cas d'un photodétecteur matriciel, d'améliorer la fonction de transfert de modulation FTM sans dégrader le facteur de remplissage. Rappelons ici que la FTM est l'une des fonctions de mérite d'un photodétecteur infrarouge matriciel, qui permet de quantifier l'incidence des grandes longueurs de diffusion d'un pixel de détection sur un pixel voisin. Plus généralement, elle permet de mesurer l'aptitude du photodétecteur matriciel à restituer les détails contenus dans une scène observée.

Notons enfin que la réalisation de la zone absorbante 11 du photodétecteur 1 permet de minimiser les risques que la zone absorbante, une fois réalisée, ne présente pas les propriétés souhaitées. En effet, dans le cas d'une zone absorbante formée entièrement d'un super-réseau T2SL de plusieurs microns d'épaisseur, il y a un risque d'une dérive des flux de dépôt utilisés pour réaliser l'alternance des couches fines, dégradant ainsi les propriétés du super-réseau, en particulier lorsque le T2SL est réalisé par épitaxie par jets moléculaires (MBE). En revanche, dans le photodétecteur 1, la deuxième partie absorbante SL 11.2 ne forme, de préférence, pas plus de la moitié de l'épaisseur de la zone absorbante. On limite ainsi les risques de dérive des flux lors de la croissance du super-réseau.

Les figures 2A et 2B sont des vues schématiques et partielles, en coupe transversale, de photodétecteurs MWIR 1 à barrière selon des différents modes de réalisation. Dans ces exemples, les photodétecteurs 1 sont matriciels, dans le sens où ils comportent une matrice de pixels de détection. Dans ces exemples, la deuxième électrode 5 repose ici au contact de la deuxième partie absorbante SL 11.2, mais elle pourrait également reposer au contact de la première partie absorbante massive 11.1 ou de la couche inférieure 3, voire au contact du substrat support 2.

En référence à la fig.2A, le photodétecteur matriciel 1 présente une configuration de pixellisation dite à gravure peu profonde (*shallow-etch* en anglais), où seule la couche contact 13 est localement gravée. Aussi, la couche barrière 12, ainsi que les couches sous-jacentes 3, 11, 12, restent continues dans le plan XY et communes à tous les pixels de détection. Ainsi, la couche contact 13 est gravée de manière à former des portions 13p distinctes les unes des autres dans le plan XY. Elle est dite réticulée. Une première électrode 4 repose sur et au contact de chaque portion 13p de la couche contact 13. Chaque pixel de détection présente ainsi des dimensions latérales dans le plan XY qui sont définies par le pas de périodicité des portions 13p de la couche contact 13 suivant les axes X et Y. Une couche de passivation 6 s'étend ici sur les flancs des portions 13p et sur la surface libre de la couche barrière 12.

Cependant, il existe encore un besoin d'améliorer la FTM du photodétecteur matriciel 1, et donc de réduire les effets de diaphotie (*crosstalk* en anglais) entre les pixels de détection, c'est-à-dire le fait qu'un porteur minoritaire photogénéré au niveau d'un pixel de détection soit collecté par le pixel de détection adjacent. En effet, la diffusion latérale des porteurs minoritaires photogénérés peut être suffisante pour entraîner de la diaphotie, en particulier pour les faibles pas des pixels de détection, et donc dégrader la FTM.

Une solution serait évidemment de réaliser des gravures profondes de pixellisation, c'est-à-dire de graver localement la structure semiconductrice 10 à barrière jusqu'au substrat support ou au moins jusqu'à la couche inférieure 3. Cependant, si cette approche conduit effectivement à améliorer la FTM, elle se traduit par une dégradation du taux de remplissage du photodétecteur matriciel. Elle peut également se traduire par une dégradation de l'efficacité quantique de chaque pixel de détection. De plus, cette gravure localisée profonde est difficile à réaliser techniquement, et peut créer des défauts au niveau des flancs, lesquels peuvent alors être difficiles à passiver et générer des fuites dégradant ainsi le courant d'obscurité de la structure.

La fig.2B illustre un photodétecteur matriciel 1 selon un mode de réalisation, qui permet d'améliorer la FTM tout en optimisant le facteur de remplissage et en limitant les problèmes de passivation des flancs des mésas 20 alors formés.

Ici, la couche contact 13, la couche barrière 12 et la deuxième partie absorbante SL 11.2 sont gravés localement pour former des mésas 20 de détection. On dit qu'elles sont réticulées (ou discrétisées). Chaque de ces couches est alors formée de plusieurs portions distinctes les unes des autres. Une mésa est une structure délimitée dans le plan XY par des flancs. Chaque mésa est donc distincte de ses voisines dans le plan XY.

En revanche, la première partie absorbante massive 11.1 n'est pas localement gravée : elle est donc continue dans le plan XY et est commune à tous les pixels de détection. Chaque pixel de détection est donc formé par une mésa 20 (portion 13p de la couche contact 13 réticulée, portion 12p de la couche barrière 12 réticulée, et portion 11.2p de la deuxième partie absorbante SL 11.2 réticulée) et par une zone sous-jacente de la première partie absorbante massive 11.1.

Cette configuration structurelle du photodétecteur matriciel 1 permet effectivement de limiter la dégradation de la FTM. En effet, il apparaît que, dans le photodétecteur matriciel de la fig.2A, la dégradation de la FTM est due en grande partie au caractère anisotrope du transport dans le super-réseau de la deuxième partie absorbante SL 11.2. Aussi, il est particulièrement avantageux de ne graver localement que la deuxième partie absorbante SL 11.2, et non pas la première partie absorbante massive 11.1. Cela permet de réduire la diaphotie et donc d'améliorer la FTM.

Notons également que l'offset dE_{g} de la bande de valence limite le transport des trous minoritaires photogénérés dans la deuxième partie absorbante SL 11.2 en direction de la première partie absorbante massive 11.1, optimisant ainsi la FTM associée à la deuxième partie absorbante SL 11.2. De plus, les porteurs issus de la première partie absorbante massive 11.1 et entrant dans la couche T2SL 11.2 ne peuvent plus repartir dans la première partie absorbante massive 11.1 pour diffuser vers les pixels voisins au sein de la couche non réticulée. La FTM associée à la première partie absorbante massive 11.1 n'est donc pas dégradée par la présence de la deuxième partie absorbante SL 11.2.

Par ailleurs, le fait de ne graver localement que la deuxième partie absorbante SL 11.2 et non pas la première partie absorbante massive 11.1 permet également d'optimiser l'efficacité quantique QE. En effet, l'efficacité quantique sera optimale dans la première partie absorbante massive 11.1 dans la mesure où elle n'est pas gravée par la pixellisation, et ne sera diminuée que dans la deuxième partie absorbante SL 11.2. Aussi, l'évolution de l'efficacité quantique QE en fonction de la longueur d'onde montre une valeur élevée dans la bande bleue, et une valeur plus faible dans la bande rouge.

De plus, dans la mesure où la deuxième partie absorbante SL 11.2 présente, de préférence une épaisseur inférieure à la moitié de l'épaisseur de la zone absorbante 11, et en particulier inférieure à la première partie absorbante massive 11.1, la gravure locale peut alors être peu profonde. La réalisation de la couche de passivation 6 est alors facilitée, et le taux de remplissage de la deuxième partie absorbante SL 11.2 est meilleur. Cette configuration de pixellisation est alors intermédiaire entre la configuration à gravure peu profonde (*shallow-etch*) et la configuration à gravure profonde (*deep-etch*). Notons enfin que la couche intermédiaire peut être utilisée comme une couche d'arrêt de gravure lors de l'étape de réalisation des mésas 20 par gravure localisée.

Des modes de réalisation particuliers viennent d'être décrits. Différentes variantes et modifications apparaîtront à l'homme du métier.

## Revendications

1. Photodétecteur infrarouge (1) à barrière, adapté à détecter un rayonnement lumineux d'intérêt présentant une longueur d'onde centrale comprise entre 3 et 5µm, comportant une structure semiconductrice (10) à barrière, réalisée à base de III-Sb, reposant sur un substrat support (2) réalisé à base de III-Sb, et formée de : une zone absorbante (11), adaptée à absorber le rayonnement lumineux d'intérêt ; une couche barrière (12) ; puis une couche contact (13) ; **caractérisé en ce que** la zone absorbante (11) est formée d'un empilement de deux parties :
∘ une première partie absorbante (11.1), dopée selon un premier type de conductivité, réalisée en un matériau massif à base d'InAsSb, située du côté du substrat support (2) ; et
∘ une deuxième partie absorbante (11.2), dopée selon le premier type de conductivité, et formée d'un super-réseau, située entre la première partie absorbante (11.1) et la couche barrière (12).

2. Photodétecteur infrarouge (1) selon la revendication 1, comportant une matrice de pixels de détection, la première partie absorbante (11.1) étant une couche continue et commune à chaque pixel de détection.

3. Photodétecteur infrarouge (1) selon la revendication 2, dans lequel la couche contact (13) est réticulée et est formée d'une pluralité de portions (13p) distinctes les unes des autres, la couche barrière (12) est réticulée et est formée d'une pluralité de portions (12p) distinctes les unes des autres, et la deuxième partie absorbante (11.2) est réticulée et est formée d'une pluralité de portions (11.2p) distinctes les unes des autres, chaque pixel de détection étant formé d'une mésa (20) reposant sur la première partie absorbante (11.1), chaque mésa (20) étant formée par une portion (13p) de la couche contact (13) réticulée, une portion (12p) de la couche barrière (12) réticulée, et une portion (11.2p) de la deuxième partie absorbante (11.2) réticulée.

4. Photodétecteur infrarouge (1) selon la revendication 2, dans lequel la couche contact (13) est réticulée et est formée d'une pluralité de portions (13p) distinctes les unes des autres, chaque pixel de détection est formé d'une portion (13p) de la couche contact (13), la deuxième partie absorbante (11.2) étant une couche continue et commune à chaque pixel de détection.

5. Photodétecteur infrarouge (1) selon l'une quelconque des revendications 2 à 4, comportant une couche intermédiaire (11.3) située entre et au contact de la première partie absorbante (11.1) et la deuxième partie absorbante (11.2), la couche intermédiaire (11.3) étant une couche continue et commune à chaque pixel de détection.

6. Photodétecteur infrarouge (1) selon l'une quelconque des revendications 1 à 5, dans lequel la première partie absorbante (11.1) est réalisée à base d'InAsSb en accord de maille avec le substrat support.

7. Photodétecteur infrarouge (1) selon l'une quelconque des revendications 1 à 6, dans lequel la deuxième partie absorbante (11.2) est réalisée à base d'InAs/InAsSb, d'InAs/AlSb ou d'InAs/GaSb.

8. Photodétecteur infrarouge (1) selon l'une quelconque des revendications 1 à 7, dans lequel la première partie absorbante (11.1) présente une épaisseur supérieure à celle de la deuxième partie absorbante (11.2).

9. Photodétecteur infrarouge (1) selon l'une quelconque des revendications 1 à 8, dans lequel la première partie absorbante (11.1) présente une épaisseur au moins égale à la moitié de celle de la zone absorbante (11).

10. Photodétecteur infrarouge (1) selon l'une quelconque des revendications 1 à 9, dans lequel la structure semiconductrice (10) à barrière est de type XBn, la bande de valence de la deuxième partie absorbante (11.2) présentant une énergie supérieure à celle de la bande de valence de la première partie absorbante (11.1), ou la structure semiconductrice (10) à barrière est de type XBp, la bande de conduction de la deuxième partie absorbante (11.2) présentant une énergie inférieure à celle de la bande de conduction de la première partie absorbante (11.1).

## Patentansprüche

1. Infrarot-Barrierefotodetektor (1), der zum Erkennen einer Lichtstrahlung von Interesse ausgelegt ist, die eine zentrale Wellenlänge zwischen 3 und 5 µm besitzt, die eine Barrierehalbleiterstruktur (10) aufweist, die auf Basis von III-Sb hergestellt ist, die auf einem Trägersubstrat (2) auf Basis von III-Sb hergestellt ist, die aus Folgendem gebildet ist: einer absorbierenden Zone (11), die zum Absorbieren der Lichtstrahlung von Interesse ausgelegt ist; einer Barriereschicht (12); dann einer Kontaktschicht (13); **dadurch gekennzeichnet, dass** die absorbierende Zone (11) aus einem Stapel von zwei Teilen gebildet ist:
∘ einem ersten absorbierenden Teil (11.1), der nach einem ersten Leitfähigkeitstyp dotiert ist, der aus einem massiven Material auf InAsSb-Basis hergestellt ist, der sich auf der Seite des Trägersubstrats (2) befindet; und
∘ einem zweiten absorbierenden Teil (11.2), der nach dem ersten Leitfähigkeitstyp dotiert und aus einem Übergitter gebildet ist, das sich zwischen dem ersten absorbierenden Teil (11.1) und der Barriereschicht (12) befindet.

2. Infrarot-Fotodetektor (1) nach Anspruch 1, der eine Detektionspixelmatrix aufweist, wobei der erste absorbierende Teil (11.1) eine durchgehende Schicht ist, die für jedes Detektionspixel gleich ist.

3. Infrarot-Fotodetektor (1) nach Anspruch 2, wobei die Kontaktschicht (13) vernetzt ist und aus einer Vielzahl von voneinander getrennten Abschnitten (13p) gebildet ist, die Barriereschicht (12) vernetzt ist und aus einer Vielzahl von voneinander getrennten Abschnitten (12p) gebildet ist, und der zweite absorbierende Teil (11.2) vernetzt ist und aus einer Vielzahl von voneinander getrennten Abschnitten (11.2p) gebildet ist, wobei jedes Detektionspixel aus einer Mesa (20) gebildet ist, die auf dem ersten absorbierenden Teil (11.1) ruht, wobei jede Mesa (20) aus einem Abschnitt (13p) der vernetzten Kontaktschicht (13), einem Abschnitt (12p) der vernetzten Barriereschicht (12) und einem Abschnitt (11.2p) des zweiten absorbierenden Teils (11.2) gebildet ist.

4. Infrarot-Fotodetektor (1) nach Anspruch 2, wobei die Kontaktschicht (13) vernetzt ist und aus einer Vielzahl von voneinander getrennten Abschnitten (13p) gebildet ist, wobei jedes Detektionspixel aus einem Abschnitt (13p) der Kontaktschicht (13) gebildet ist, wobei der zweite absorbierende Teil (11.2) eine durchgehende Schicht ist, die für jedes Detektionspixel gleich ist.

5. Infrarot-Fotodetektor (1) nach einem der Ansprüche 2 bis 4, mit einer Zwischenschicht (11.3), die sich zwischen und in Kontakt mit dem ersten absorbierenden Teil (11.1) und dem zweiten absorbierenden Teil (11.2) befindet, wobei die Zwischenschicht (11.3) eine durchgehende Schicht ist, die für jedes Detektionspixel gleich ist.

6. Infrarot-Fotodetektor (1) nach einem der Ansprüche 1 bis 5, wobei der erste absorbierende Teil (11.1) auf Basis von InAsSb in Netzabstimmung mit dem Trägersubstrat hergestellt ist.

7. Infrarot-Fotodetektor (1) nach einem der Ansprüche 1 bis 6, wobei der zweite absorbierende Teil (11.2) auf Basis von InAs/InAsSb, InAs/AlSb oder InAs/GaSb hergestellt ist.

8. Infrarot-Fotodetektor (1) nach einem der Ansprüche 1 bis 7, wobei der erste absorbierende Teil (11.1) eine größere Dicke besitzt als der zweite absorbierende Teil (11.2).

9. Infrarot-Fotodetektor (1) nach einem der Ansprüche 1 bis 8, wobei der erste absorbierende Teil (11.1) eine Dicke besitzt, die mindestens der Hälfte der Dicke der absorbierenden Zone (11) entspricht.

10. Infrarot-Fotodetektor (1) nach einem der Ansprüche 1 bis 9, wobei die Barrierehalbleiterstruktur (10) vom Typ XBn ist, wobei das Valenzband des zweiten absorbierenden Teils (11.2) eine höhere Energie besitzt als das Valenzband des ersten absorbierenden Teils (11.1), oder die Barrierehalbleiterstruktur (10) vom Typ XBp ist, wobei das Leitband des zweiten absorbierenden Teils (11.2) eine geringere Energie als das Leitband des ersten absorbierenden Teils (11.1) besitzt.

## Claims

1. An infrared barrier photodetector (1), adapted to detect a light radiation of interest having a central wavelength between 3 and 5µm, comprising a semiconductor barrier structure (10), produced based on III-Sb, resting on a support substrate (2) produced based on III-Sb, and formed of: an absorbing zone (11), adapted to absorb the light radiation of interest; a barrier layer (12); and a contact layer (13); **characterized in that** the absorbing zone (11) is formed of a two-part stack:
∘ a first absorbing part (11.1), doped according to a first conductivity type, made of a bulk material based on InAsSb, located on the support substrate (2) side; and
∘ a second absorbing part (11.2), doped according to the first conductivity type, and formed of a superlattice, located between the first absorbing part (11.1) and the barrier layer (12).

2. The infrared photodetector (1) according to claim 1, comprising a detection pixel array, the first absorbing part (11.1) being a continuous layer common to each detection pixel.

3. The infrared photodetector (1) according to claim 2, wherein the contact layer (13) is crosslinked and is formed of a plurality of portions (13p) distinct from each other, the barrier layer (12) is crosslinked and is formed of a plurality of portions (12p) distinct from each other, and the second absorbing part (11.2) is crosslinked and is formed of a plurality of portions (11.2p) distinct from each other, each detection pixel being formed of a mesa (20) resting on the first absorbing part (11.1), each mesa (20) being formed by a portion (13p) of the crosslinked contact layer (13), a portion (12p) of the crosslinked barrier layer (12), and a portion (11.2p) of the crosslinked second absorbing part (11.2).

4. The infrared photodetector (1) according to claim 2, wherein the contact layer (13) is crosslinked and is formed of a plurality of portions (13p) distinct from each other, each detection pixel being formed of a portion (13p) of the contact layer (13), the second absorbing part (11.2) being a continuous layer common to each detection pixel.

5. The infrared photodetector (1) according to any one of claims 2 to 4, comprising an intermediate layer (11.3) located between and in contact with the first absorbing part (11.1) and the second absorbing part (11.2), the intermediate layer (11.3) being a continuous layer common to each detection pixel.

6. The infrared photodetector (1) according to any one of claims 1 to 5, wherein the first absorbing part (11.1) is produced based on InAsSb lattice-matched with the support substrate.

7. The infrared photodetector (1) according to any one of claims 1 to 6, wherein the second absorbing part (11.2) is produced based on InAs/InAsSb, InAs/AlSb or InAs/GaSb.

8. The infrared photodetector (1) according to any one of claims 1 to 7, wherein the first absorbing part (11.1) has a thickness greater than that of the second absorbing part (11.2).

9. The infrared photodetector (1) according to any one of claims 1 to 8, wherein the first absorbing part (11.1) has a thickness at least equal to half that of the absorbing zone (11).

10. The infrared photodetector (1) according to any one of claims 1 to 9, wherein the semiconductor barrier structure (10) is XBn-type, the valence band of the second absorbing part (11.2) having a greater energy than that of the valence band of the first absorbing part (11.1), or the semiconductor barrier structure (10) is XBp-type, the conduction band of the second absorbing part (11.2) having a lower energy than that of the conduction band of the first absorbing part (11.1).
